# EUROPÄISCHE PATENTANMELDUNG

(11) **EP 1 816 743 A1**
(43) Veröffentlichungstag der Anmeldung: **08.08.2007**
(21) Anmeldenummer: 07001812.2
(22) Anmeldetag: 27.01.2007
(51) Int. Cl.: H03H 7/01, H03H 11/12, H03K 4/50, G01R 27/26, H03J 5/02

(54) **Verfahren und Schaltung zum Abgleichen eines RC-Gliedes**

(30) Priorität: 03.02.2006 DE 102006005778
(71) Anmelder: ATMEL Germany GmbH, 74072 Heilbronn (DE)
(72) Erfinder: Dathe, Lutz, 01109 Dresden (DE); Drescher, Henry, 01445 Radebeul (DE)

(57) **Zusammenfassung**

Die Erfindung betrifft ein Verfahren zum Abgleichen eines RC-Gliedes mit einem kapazitiven Element (200) mit einstellbarer Kapazität, insbesondere einem Kondensator, und/oder einem resistiven Element mit einstellbarem Widerstand, insbesondere einem Ohmwiderstand.

Erfindungsgemäß werden mehrere Abgleichzyklen durchgeführt, wobei jeder Abgleichzyklus die folgenden Schritte aufweist:
a) Einstellen eines Vorgabewerts für die Kapazität des kapazitiven Elements (200) und/oder für den Widerstand des resistiven Elements,
b) Aufladen des kapazitiven Elements (200) für eine vorgebbare Ladezeit,
c) Vergleichen einer Ladespannung, auf die das kapazitive Element (200) während der Ladezeit aufgeladen worden ist, mit einer Referenzspannung (V_ref), wobei ein Vergleichsergebnis erhalten wird, das angibt, ob die Ladespannung größer ist als die Referenzspannung (V_ref) oder umgekehrt.

Ferner wird der Vorgabewert für die Kapazität und/oder den Widerstand und/oder die Ladezeit für einen nachfolgenden Abgleichzyklus in Abhängigkeit des Vergleichsergebnisses mindestens eines vorhergehenden Abgleichzyklus gewählt.

## Beschreibung

Die Erfindung betrifft ein Verfahren zum Abgleichen eines RC-Gliedes mit einem kapazitiven Element mit einstellbarer Kapazität, insbesondere einem Kondensator, und/oder einem resistiven Element mit einstellbarem Widerstand, insbesondere einem Ohmwiderstand. Ferner betrifft die Erfindung eine Schaltung zum Abgleichen eines derartigen RC-Gliedes.

Aus der DE 101 56 027 A1 ist ein Verfahren zum Abgleichen eines aktiven Filters mit einer die Zeitkonstante des Filters bestimmenden RC-Kombination bekannt. Das bekannte Verfahren sieht vor, die RC-Kombination an einen Signalgenerator anzuschließen, der ein von den tatsächlichen Bauteilwerten der RC-Kombination abhängiges Rechtecksignal erzeugt. Das Rechtecksignal wird einem Freigabeeingang eines Zählers zugeführt, um diejenige Anzahl von Taktzyklen eines ebenfalls dem Zähler zugeführten Taktsignals zu ermitteln, die der Pulsdauer des Rechtecksignals entsprechen. Die Anzahl der Taktzyklen ist proportional zu der durch die RC-Kombination definierten Zeitkonstante.

Nachteilig an diesem Verfahren bzw. der entsprechenden Schaltung ist insbesondere die durch eine Taktfrequenz des Taktsignals begrenzte Auflösung bei der Messung der Pulsdauer des Rechtecksignals. D.h., um eine hinreichend hohe Auflösung zur Messung und Darstellung der Pulsdauer des Rechtecksignals zu erhalten, muss ein entsprechend hochfrequentes Taktsignal vorgesehen werden. Dies wiederum erfordert den Einsatz eines Zählers mit ausreichender Datenbreite, damit auch eine entsprechende Auswertung der Pulsdauer vorgenommen werden kann.

Ferner ist speziell bei einem hochfrequenten Taktsignal die Abbildung eines die Pulsdauer repräsentierenden Datenworts des Zählers auf ein das Kondensatorfeld steuerndes Datenwort mittels des in der DE 101 56 027 A1 angegebenen Decoders insbesondere bei der Verwendung einer Lookup-Table sehr aufwendig, da die Lookup-Table ebenfalls eine entsprechende Größe aufweisen muss.

Eine Abhilfe, um bei dem beschriebenen Verfahren kein hochfrequentes Taktsignal einsetzen zu müssen und dennoch eine ausreichende Genauigkeit zu erzielen, besteht darin, für die RC-Kombination entsprechend große Bauteilwerte vorzusehen, d.h. die Pulsdauer des von dem Signalgenerator erzeugten Rechtecksignals und damit den Meßzeitraum größer zu machen. Dies wirkt sich insbesondere bei der kapazitiven Komponente der RC-Kombination nachteilig auf den Flächenbedarf aus, wodurch sich die Integrierbarkeit der Schaltung verschlechtert.

Demgemäß ist es Aufgabe der Erfindung, ein Verfahren und eine Schaltung der eingangs genannten Art dahingehend zu verbessern, dass ein präziserer Abgleich des RC-Gliedes und eine verbesserte Integrierbarkeit der Schaltung gegeben ist.

Diese Aufgabe wird bei dem Verfahren der eingangs genannten Art erfindungsgemäß dadurch gelöst, dass mehrere Abgleichzyklen durchgeführt werden, wobei jeder Abgleichzyklus die folgenden Schritte aufweist:
a) Einstellen eines Vorgabewerts für die Kapazität des kapazitiven Elements und/oder für den Widerstand des resistiven Elements,
b) Aufladen des kapazitiven Elements für eine vorgebbare Ladezeit,
c) Vergleichen einer Ladespannung, auf die das kapazitive Element während der Ladezeit aufgeladen worden ist, mit einer vorgebbaren Referenzspannung, wobei ein Vergleichsergebnis erhalten wird, das angibt, ob die Ladespannung größer ist als die Referenzspannung oder umgekehrt,
und dass der Vorgabewert für die Kapazität und/oder den Widerstand und/oder die Ladezeit für einen nachfolgenden Abgleichzyklus in Abhängigkeit des Vergleichsergebnisses mindestens eines vorhergehenden Abgleichzyklus gewählt wird.

Durch das erfindungsgemäße Verfahren unter Verwendung mehrerer Abgleichzyklen entfällt das von den herkömmlichen Verfahren bekannte Erfordernis, die Pulsdauer eines Signals auszumessen, das eigens für den Abgleichvorgang in Abhängigkeit des abzugleichenden kapazitiven Elements erzeugt wird.

Das erfindungsgemäße Verfahren ermöglicht vielmehr durch eine z.B. schrittweise Änderung des Vorgabewerts für die Kapazität des kapazitiven Elements zwischen aufeinanderfolgenden Abgleichzyklen, den optimalen Vorgabewert für die Kapazität des kapazitiven Elements zu ermitteln, bei dem die nach der Ladezeit vorliegende Ladespannung im Bereich der vorgebbaren Referenzspannung liegt. Die vorgebbare Referenzspannung ist so gewählt, dass sie derjenigen Ladespannung entspricht, die ein vollständig abgeglichenes kapazitives Element dann aufweist, wenn es bei gegebener Ladezeit und Aufladeweise aufgeladen wird. Unter einem vollständig abgeglichenen kapazitiven Element wird dabei ein kapazitives Element verstanden, dessen tatsächliche Kapazität der angestrebten Sollkapazität entspricht.

Das Erreichen des optimalen Vorgabewerts für die Kapazität kann in einfacher Weise durch eine Änderung des Vergleichsergebnisses zwischen zwei aufeinanderfolgenden Abgleichzyklen erkannt werden. Beispielsweise kann für eine erste Anzahl von Abgleichzyklen mit einer ersten Auswahl von Vorgabewerten für die Kapazität das Vergleichsergebnis stets angeben, dass die Ladespannung kleiner ist als die Referenzspannung. In diesen Fällen sind die entsprechend gewählten Vorgabewerte für die Kapazität jeweils zu groß verglichen mit dem optimalen Vorgabewert, weil die Referenzspannung während der Ladezeit nicht erreicht wird.

Sobald nach einem weiteren Abgleichzyklus erstmals ein abweichendes Vergleichsergebnis erzielt wird, das angibt, dass die Ladespannung größer ist als die Referenzspannung, kann darauf geschlossen werden, dass der optimale Vorgabewert für die Kapazität zwischen dem momentan eingestellten Vorgabewert und dem für den vorherigen Abgleichzyklus eingestellten Vorgabewert liegt.

Demnach ist zur Eingrenzung des optimalen Vorgabewerts für die Kapazität bei dem erfindungsgemäßen Verfahren nur die mehrfache Durchführung eines verhältnismäßig einfachen Abgleichzyklus und eine einfache Auswertung in Form eines Vergleichs zweier Spannungswerte erforderlich. Eine wesentlich aufwendigere Ausmessung der Pulsdauer eines Referenzsignals und eine dementsprechend komplexe Steuerung bzw. der Einsatz eines Zählerbausteins zur Ermittlung einer variablen Zeitdauer, der bei herkömmlichen Abgleichverfahren notwendig ist, entfällt.

Ferner kann die gewünschte Präzision bei der Annäherung des Vorgabewerts für die Kapazität z.B. allein durch die entsprechende Auswahl von für die einzelnen Abgleichzyklen einzustellenden Vorgabewerten erfolgen. Die Verwendung eines hochfrequenten Taktsignals ist nicht erforderlich. Darüber hinaus kann die Präzision des Abgleichs mit dem erfindungsgemäßen Verfahren durch die Auswahl des Abgleichalgorithmus beeinflusst werden, ohne dass z.B. größere Bauteilwerte für das kapazitive Element vorzusehen sind, die zu einer schlechten Integrierbarkeit der herkömmlichen Schaltungen führen.

Generell ist bei einer vorteilhaften Ausführungsform des erfindungsgemäßen Verfahrens dementsprechend vorgesehen, dass der Vorgabewert für die Kapazität für den nächsten Abgleichzyklus erhöht/verringert wird, wenn die Ladespannung bei dem vorhergehenden Abgleichzyklus größer/kleiner war als die Referenzspannung.

Alternativ oder ergänzend zu der Veränderung des Vorgabewerts für die Kapazität kann auch ein Vorgabewert für das einstellbare resistive Element in vergleichbarer Weise geändert werden, um die Zeitkonstante des RC-Gliedes entsprechend zu ändern. Generell kann ein abzugleichendes RC-Glied demnach sowohl abstimmbare als auch nicht abstimmbare kapazitive und resistive Komponenten aufweisen, wobei jedoch mindestens ein abstimmbares resistives oder kapazitives Element vorhanden sein muss.

Alternativ zu einer Änderung des Vorgabewerts für die Kapazität und/oder den Widerstand kann erfindungsgemäß auch eine Änderung der Ladezeit für einen nachfolgenden Abgleichzyklus erfolgen. Dadurch ist es für einen gegebenen Wertebereich der einstellbaren Kapazität des kapazitiven Elements z.B. möglich, für den Schritt des Vergleichens der Ladespannung mit der Referenzspannung ein kapazitives Element mit einer anderen als der tatsächlich eingestellten Kapazität nachzubilden. Beispielsweise kann bei der Einstellung des größtmöglichen Vorgabewerts für die Kapazität durch eine Halbierung der Ladezeit und unter Annahme eines konstanten Ladestroms der Aufladevorgang eines kapazitiven Elements mit doppelter Kapazität nachgebildet werden, usw. Dementsprechend kann zumindest die Ermittlung des tatsächlichen Kapazitätswerts des kapazitiven Elements innerhalb eines größeren Wertebereichs erfolgen, als dies ohne eine Variation der Ladezeit möglich ist. Entsprechendes gilt für eine Erweiterung eines gegebenen Wertebereichs für den Widerstand des resistiven Elements.

Dementsprechend ist bei einer anderen vorteilhaften Ausführungsform des erfindungsgemäßen Verfahrens vorgesehen, dass die Ladezeit für den nächsten Abgleichzyklus erhöht/verringert wird, wenn die Ladespannung bei dem vorhergehenden Abgleichzyklus kleiner/größer war als die Referenzspannung.

Bei einer besonders bevorzugten Ausführungsform des erfindungsgemäßen Verfahrens ist vorgesehen, dass das kapazitive Element durch eine Ladeschaltung mit einem konstanten Strom aufgeladen wird. Durch den dabei gegebenen linearen Zusammenhang zwischen der Kondensatorspannung und der Ladezeit weist die zeitliche Änderung der Ladespannung einen konstanten Wert auf, so dass auch für unterschiedliche Ladezeiten vergleichbare Genauigkeiten bei dem Vergleich der Ladespannung mit der Referenzspannung erzielt werden. Aufgrund des linearen Zusammenhangs zwischen der Ladezeit und der Kapazität eines mittels eines konstanten Ladestroms aufgeladenen Kondensators ist diese Verfahrensvariante besonders einfach mit der bereits beschriebenen Variation der Ladezeit kombinierbar.

Obwohl das Aufladen des kapazitiven Elements mit einem konstanten Strom die bevorzugte Variante darstellt, ist es bei einer weiteren Ausführungsform des erfindungsgemäßen Verfahrens auch denkbar, dass das kapazitive Element mittels einer Ladeschaltung über einen Vorwiderstand und eine Referenzspannungsquelle aufgeladen wird, wobei der Vorwiderstand vorzugsweise zumindest teilweise durch das resistive Element gebildet ist. Hierzu weist die Ladeschaltung einen entsprechend ausgebildeten Referenzwiderstand als Vorwiderstand auf, der in Serie zu dem kapazitiven Element schaltbar ist, und die sich hieraus ergebende Serienschaltung wird mittels der Referenzspannungsquelle aufgeladen. Bei dieser Variante wird die Ladezeit vorteilhaft so gewählt, dass sie kleiner oder gleich einer Zeitkonstante ist, die sich durch den Referenzwiderstand und den Vorgabewert für die Kapazität des kapazitiven Elements bestimmt, um den asymptotischen Bereich des zeitlichen Verlaufs der Ladespannung und die damit einhergehenden Nachteile einer verringerten Empfindlichkeit der Ladespannung gegenüber der Ladezeit zu vermeiden.

Bei einer weiteren sehr vorteilhaften Ausführungsform des erfindungsgemäßen Verfahrens ist vorgesehen, dass als Vorgabewert für einen ersten Abgleichzyklus eine maximal bzw. minimal einstellbare Kapazität des kapazitiven Elements und/oder ein maximal bzw. minimal einstellbarer Widerstand des resistiven Elements gewählt wird. Dadurch ist vorteilhaft ein systematisches Absuchen des gesamten Wertebereichs der Kapazität des kapazitiven Elements bzw. des Widerstands des resistiven Elements auf den optimalen Vorgabewert hin möglich.

Gemäß einer weiteren vorteilhaften Verfahrensvariante wird der Vorgabewert, bei dem es sich generell um den Vorgabewert für die Kapazität und/oder um den Vorgabewert für den Widerstand handeln kann, zwischen aufeinanderfolgenden Abgleichzyklen jeweils um eine vorgebbare Schrittweite geändert. Eine Veränderung z.B. der Kapazität mit konstanter Schrittweite ist beispielsweise bei solchen kapazitiven Elementen möglich, die aus einer Vielzahl von einzelnen Kondensatoren mit gleicher Kapazität gebildet sind, welche z.B. unter Steuerung einer entsprechenden Schaltermatrix parallel zueinander schaltbar sind, um durch ihre sich dabei ergebende Ersatzkapazität die Kapazität des kapazitiven Elements zu bilden.

Es sind auch andere Anordnungen von einzelnen Kondensatoren denkbar, die mittels einer Schaltermatrix das schrittweise Realisieren unterschiedlicher Ersatzkapazitäten ermöglichen. Beispielsweise können verschiedene Kondensatoren mit z.B. binär gestuften Kapazitätswerten parallel miteinander verschaltbar angeordnet sein, um eine binäre Abstufung von Vorgabewerten für die Kapazität des kapazitiven Elements zu ermöglichen. Analoge Strukturen zur Realisierung unterschiedlicher Widerstandswerte können in vergleichbarer Weise aufgebaut sein.

Eine derartige Veränderung des Vorgabewerts für die Kapazität mit variabler Schrittweite ermöglicht einen besonders präzisen Abgleich des kapazitiven Elements. Beispielsweise kann in einem ersten Durchgang das erfindungsgemäße Verfahren mit einer verhältnismäßig großen Schrittweite für den Vorgabewert durchgeführt werden, um das Intervall zwischen denjenigen Vorgabewerten zu ermitteln, in dem sich der optimale Vorgabewert befindet. Anschließend kann in einem zweiten Durchgang das erfindungsgemäße Verfahren mit einer verhältnismäßig kleinen Schrittweite für den Vorgabewert durchgeführt werden, um das noch näher zu untersuchende Intervall zu verkleinern.

Besonders vorteilhaft ist bei einer anderen Ausführungsform des erfindungsgemäßen Verfahrens vorgesehen, dass die Schrittweite in Abhängigkeit der Anzahl bereits durchgeführter Abgleichzyklen gewählt wird. Dabei kann zu Beginn des erfindungsgemäßen Verfahrens mit großen Schrittweiten für den Vorgabewert gearbeitet werden, und mit zunehmender Anzahl an Abgleichzyklen verringert sich die Schrittweite entsprechend, wobei gleichzeitig die Genauigkeit des Verfahrens steigt.

Eine andere sehr vorteilhafte Ausführungsform des erfindungsgemäßen Verfahrens ist durch die folgenden Schritte gekennzeichnet:
- Beibehalten der momentanen Schrittweite für den nächsten Abgleichzyklus, falls das Vergleichsergebnis des aktuellen Abgleichzyklus identisch ist mit dem Vergleichsergebnis des vorhergehenden Abgleichzyklus,
- Verringern, insbesondere Halbieren, der momentanen Schrittweite für den nächsten Abgleichzyklus, falls das Vergleichsergebnis des aktuellen Abgleichzyklus nicht identisch ist mit dem Vergleichsergebnis des vorhergehenden Abgleichzyklus,
- Beenden des Abgleichs, sobald die für den nächsten Abgleichzyklus gewählte Schrittweite einen vorgebbaren Schwellwert unterschreitet.

Falls nämlich das Vergleichsergebnis des aktuellen Abgleichzyklus identisch ist mit dem Vergleichsergebnis des vorhergehenden Abgleichzyklus, kann davon ausgegangen werden, dass die Änderung des Vorgabewerts für die Kapazität zwischen diesen Abgleichzyklen eine weitere Annäherung an den Sollwert bewirkt hat und nicht bereits ein Überschreiten des Sollwerts. Dementsprechend kann mit derselben Schrittweite ein nachfolgender Abgleichzyklus durchgeführt werden.

Falls jedoch das Vergleichsergebnis des aktuellen Abgleichzyklus nicht identisch ist mit dem Vergleichsergebnis des vorhergehenden Abgleichzyklus, kann davon ausgegangen werden, dass die Änderung des Vorgabewerts für die Kapazität zwischen den beiden Abgleichzyklen bereits ein Überschreiten des Sollwerts bewirkt hat, so dass zu einer weiteren Annäherung des Vorgabewerts für die Kapazität an den Sollwert bei einem folgenden Abgleichzyklus einerseits eine Veränderung des Vorgabewerts in der anderen als der seitherigen Richtung erforderlich ist. Andererseits wird die Schrittweite erfindungsgemäß gleichzeitig verkleinert, um eine bessere Annäherung an den Sollwert zu ermöglichen. Damit ergibt sich vorteilhaft eine asymptotische Annäherung des Vorgabewerts an den Sollwert, und die Präzision dieser Verfahrensvariante ist nur durch die kleinstmöglich einstellbare Schrittweite der Kapazität begrenzt.

Auch bei der vorstehend beschriebenen Ausführungsform des erfindungsgemäßen Verfahrens ist alternativ oder auch ergänzend zu der Variation des Vorgabewerts für die Kapazität auch eine entsprechende Variation des Vorgabewerts für den Widerstand denkbar.

Besonders vorteilhaft ist bei einer weiteren Ausführungsform des erfindungsgemäßen Verfahrens vorgesehen, dass das kapazitive Element nach dem Schritt des Vergleichens entladen wird. Damit wird sichergestellt, dass bei jedem Schritt des Aufladens stets dieselben Verhältnisse vorliegen, nämlich ein absolut entladenes kapazitives Element. Alternativ oder zusätzlich kann das Entladen des kapazitiven Elements auch vor dem Schritt des Aufladens bzw. Einstellens des Vorgabewerts erfolgen.

Bei einer weiteren vorteilhaften Verfahrensvariante ist vorgesehen, dass eine zum Aufladen des kapazitiven Elements verwendete Ladeschaltung vor dem Schritt des Vergleichens von dem kapazitiven Element getrennt wird, so dass sich die Ladespannung nicht während des Vergleichens ändert.

Als eine weitere Lösung der Aufgabe der vorliegenden Erfindung ist eine Schaltung gemäß Patentanspruch 14 angegeben. Die erfindungsgemäße Schaltung zum Abgleichen eines RC-Gliedes mit einem kapazitiven Element, insbesondere einem Kondensator, und/oder einem resistiven Element mit einstellbarem Widerstand, insbesondere einem Ohmwiderstand, weist die folgenden Elemente auf: eine mindestens mit einem ersten Anschluss des kapazitiven Elements verbindbare Ladeschaltung zum Aufladen des kapazitiven Elements, eine Komparatorschaltung mit einem ersten Eingang, einem zweiten Eingang und mit einem Ausgang, wobei dem ersten Eingang ein einer Referenzspannung entsprechendes Bezugspotential zugeführt ist, und wobei der zweite Eingang mit dem ersten Anschluss des kapazitiven Elements verbindbar ist, und eine Steuereinrichtung, die zur Steuerung der Schaltung nach dem erfindungsgemäßen Abgleichverfahren konfiguriert ist.

Im Gegensatz zu herkömmlichen Abgleichschaltungen benötigt die erfindungsgemäße Schaltung besonders vorteilhaft keine Zählerschaltung zur Bestimmung einer variablen Zeitdauer, wie sie beispielsweise bei bekannten Schaltungen benötigt wird, um eine Pulsdauer eines Referenzsignals auszumessen. Allenfalls ist bei der Anwendung des erfindungsgemäßen Verfahrens die Festlegung der Ladezeit erforderlich, die beispielsweise als ganzzahliges Vielfaches der Periodendauer eines Taktsignals mit bekannter und v.a. konstanter Frequenz definiert werden kann. Dadurch entfällt die Notwendigkeit, ein hochfrequentes Taktsignal bereitzustellen, dessen Frequenz so groß gewählt werden muss, dass eine auszumessende Pulsdauer eines Referenzsignals so viele Perioden des hochfrequenten Taktsignals aufnimmt, dass damit eine hinreichende Messgenauigkeit bei der Messung der Pulsdauer erzielt wird.

Sehr vorteilhaft kann die Steuereinrichtung gemäß einer weiteren Erfindungsvariante einen Zustandsautomaten aufweisen und/oder als Zustandsautomat ausgebildet sein.

Bei einer weiteren bevorzugten Ausführungsform der erfindungsgemäßen Schaltung ist eine mit mindestens einem Anschluss des kapazitiven Elements verbindbare Entladeschaltung zum Entladen des kapazitiven Elements vorgesehen. Die Entladeschaltung kann in einer besonders einfachen Variante einen Schalter aufweisen, der den Anschluss des kapazitiven Elements mit einem Bezugspotential wie z.B. dem Massepotential verbindet. Ebenso wie die Verbindung der Ladeschaltung mit dem kapazitiven Element durch entsprechende Schaltermittel ist auch die Entladeschaltung vorzugsweise durch die Steuereinrichtung steuerbar.

Eine andere sehr vorteilhafte Ausführungsform der vorliegenden Erfindung ist gekennzeichnet durch eine Taktgeberschaltung zur Erzeugung eines Taktsignals. Aus diesem Taktsignal kann - wie bereits beschrieben - direkt ein die Ladezeit definierendes Steuersignal abgeleitet werden.

Weitere Vorteile, Merkmale und Einzelheiten ergeben sich aus der nachfolgenden Beschreibung, in der unter Bezugnahme auf die Zeichnung verschiedene Ausführungsbeispiele der Erfindung dargestellt sind. Dabei können die in den Ansprüchen und in der Beschreibung erwähnten Merkmale jeweils einzeln für sich oder in beliebiger Kombination erfindungswesentlich sein.

In der Zeichnung zeigt:
- Figur 1: schematisch eine Ausführungsform der erfindungsgemäßen Schaltung,
- Figur 2: eine Detailansicht des in Figur 1 abgebildeten kapazitiven Elements,
- Figur 3a: ein Flussdiagramm einer Ausführungsform des erfindungsgemäßen Abgleichverfahrens, und
- Figur 3b: ein weiteres Flussdiagramm einer Ausführungsform des erfindungsgemäßen Abgleichverfahrens.

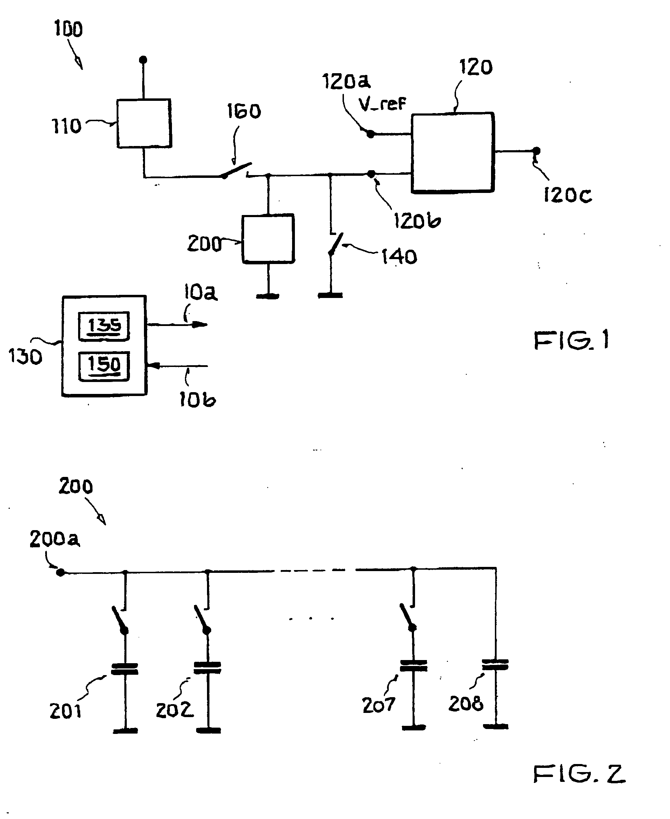

In Figur 1 ist eine Ausführungsform der erfindungsgemäßen Schaltung 100 zum Abgleich eines RC-Gliedes schematisch dargestellt. Das RC-Glied weist neben dem gezeigten kapazitiven Element 200, das z.B. durch einen Kondensator gebildet ist, noch mindestens einen nicht gezeigten Ohmwiderstand auf. In dem vorliegenden Beispiel erfolgt der Abgleich des RC-Gliedes durch einen Abgleich seines kapazitiven Elements 200. Bei dem abzugleichenden RC-Glied kann es sich beispielsweise um ein RC-Glied handeln, das in Filterschaltungen verwendet wird, um eine Zeitkonstante τ = RC der Filterschaltung zu realisieren. Um die Kapazität des Kondensators 200 bzw. eine davon abhängige Zeitkonstante auf einen gewünschten Sollwert abzugleichen wird die nachstehend beschriebene erfindungsgemäße Abgleichschaltung 100 zum Abgleich temporär mit dem Kondensator 200 verbunden. Eine derartige Verbindung kann beispielsweise über entsprechende, nicht abgebildete Schalter erfolgen, über die der Kondensator 200 nach dem Abgleichvorgang beispielsweise wieder mit der Filterschaltung verbindbar ist.

Die Abgleichschaltung 100 weist eine Ladeschaltung 110 zum Laden des Kondensators 200 auf, die über einen Schalter 160 mit einem ersten Anschluss des Kondensators 200 verbindbar ist. Ein zweiter Anschluss des Kondensators 200 ist - wie aus Figur 1 ersichtlich - mit dem Massepotential verbunden.

Ferner weist die Abgleichschaltung 100 eine Entladeschaltung 140 auf, die in dem vorliegenden Beispiel als einfacher Schalter ausgebildet und zur Entladung des Kondensators 200 vorgesehen ist. Zum Entladen des Kondensators 200 wird der Schalter 140 geschlossen, und während der Kondensator 200 z.B. über die Ladeschaltung 110 aufgeladen wird, bleibt der Schalter 140 geöffnet.

Die erfindungsgemäße Abgleichschaltung 100 weist darüber hinaus auch eine Komparatorschaltung 120 auf, die zwei Eingänge 120a, 120b sowie einen Ausgang 120c besitzt. Die Komparatorschaltung 120 vergleicht zwei an ihren Eingängen 120a, 120b zugeführte Potentiale bzw. Spannungen miteinander und gibt in Abhängigkeit des Vergleichs in bekannter Weise an ihrem Ausgang 120c ein entsprechendes Logiksignal aus.

Zur Steuerung der Abgleichschaltung 100 ist ferner eine Steuereinrichtung 130 vorgesehen, die an ihren nicht näher bezeichneten Eingängen Betriebsinformationen der Abgleichschaltung 100 repräsentierende Eingangssignale 10b empfängt und an ihren Ausgängen Steuersignale 10a ausgibt. Beispielsweise wird der Zustand der Entladeschaltung 140 bzw. des Schalters 160, der die Ladeschaltung 110 mit dem Kondensator 200 verbindet, von der Steuereinrichtung 130 gesteuert. Die Auswertung des an dem Ausgang 120c der Komparatorschaltung 120 ausgegebenen Logiksignals erfolgt ebenfalls durch die Steuereinrichtung 130.

Die Steuereinrichtung 130 weist vorteilhaft einen Zustandsautomaten 135 zur Ablaufsteuerung auf. Um eine Zeitbasis für das nachstehend beschriebene Abgleichverfahren zur Verfügung zu stellen, kann die Steuereinrichtung 130 auch eine Taktgeberschaltung 150 umfassen. Alternativ kann der Steuereinrichtung 130 auch von einer weiteren Schaltungskomponente (nicht gezeigt) ein Taktsignal zugeführt werden.

Um den Abgleich des Kondensators 200 auf einen vorgegebenen Sollwert durchzuführen, wird das erfindungsgemäße Abgleichverfahren durchgeführt, das nachfolgend anhand der Flussdiagramme in den Figuren 3a, 3b näher beschrieben wird.

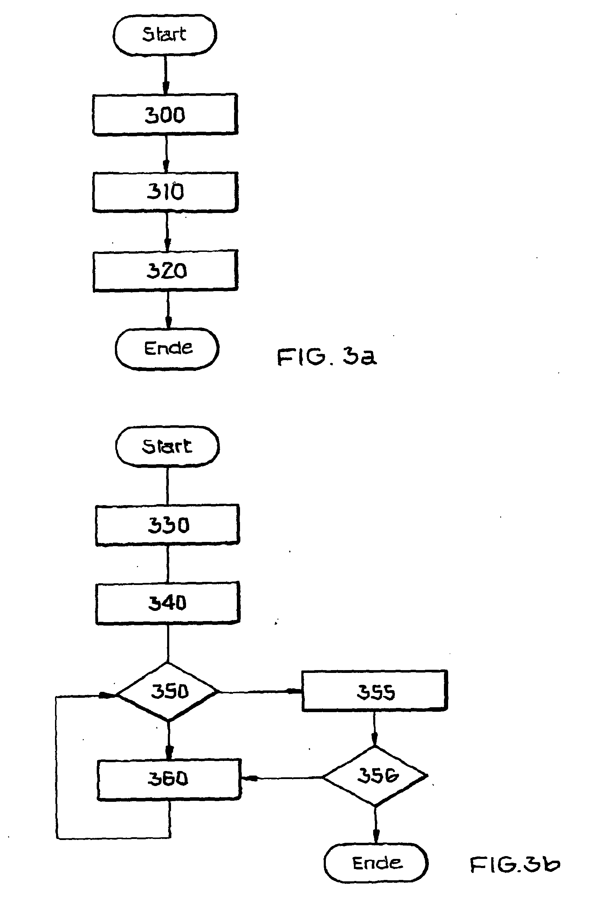

Das Abgleichverfahren umfasst mehrere Abgleichzyklen, wobei jeder Abgleichzyklus im wesentlichen drei Schritte aufweist. In dem ersten Schritt 300 jedes Abgleichzyklus (Figur 3a) wird zunächst ein Vorgabewert für die Kapazität des Kondensators 200 eingestellt. Im vorliegenden Beispiel ist der Kondensator 200 wie in Figur 2 dargestellt durch eine Parallelschaltung mehrere einzelner Kondensatoren 201, 202, .., 207, 208 realisiert, und die Einstellung der Kapazität kann durch entsprechende Ansteuerung der den einzelnen Kondensatoren zugeordneten Schalter erfolgen, die in Figur 2 nicht näher bezeichnet sind.

Wie aus Figur 2 ersichtlich, ist allein der Kondensator 208 fest mit dem Anschluss 200a verbunden und bildet somit durch seine Kapazität gleichzeitig die minimal mögliche Ersatzkapazität des Kondensators 200. Dementsprechend ergibt sich die maximal mögliche Kapazität des Kondensators 200 dann, wenn alle weiteren einzelnen Kondensatoren 201, 202, .., 207 durch Schließen der ihnen zugeordneten Schalter zueinander parallel geschaltet sind.

Die Kapazitätswerte der einzelnen Kondensatoren 201, .., 208 können an sich beliebig verteilt sein. Besonders einfache Varianten sehen beispielsweise vor, dass die einzelnen Kondensatoren 201, .., 208 jeweils dieselbe Kapazität aufweisen. Eine bevorzugte Ausführungsform sieht vorteilhaft vor, dass die einzelnen Kondensatoren 201, .., 208 binär gestufte Kapazitätswerte aufweisen, wodurch ein größerer maximaler Wertebereich für die Ersatzkapazität erzielbar ist. Die binäre Stufung der Kapazitätswerte der einzelnen Kondensatoren 201, .., 208 kann beispielsweise derart erfolgen, dass benachbarte Kondensatoren 201, 202 eine sich um den Faktor zwei unterscheidende Kapazität aufweisen.

Die Einstellung des Vorgabewerts für die Kapazität gemäß Schritt 300 aus Figur 3a erfolgt durch die Steuereinrichtung 130 (Figur 1), die durch entsprechende Ausgangssignale 10a die Schalter der einzelnen Kondensatoren 201, .., 208 (Figur 2) ansteuert. Beispielsweise wird für den ersten Abgleichzyklus die minimal mögliche Kapazität eingestellt, d.h. alle in Figur 2 abgebildeten Schalter sind geöffnet.

In dem zweiten Schritt 310 (Figur 3a) des erfindungsgemäßen Abgleichzyklus wird der Kondensator 200 für eine vorgebbare Ladezeit aufgeladen. Dies erfolgt durch ein Schließen des Schalters 160 (Figur 1), durch das die Ladeschaltung 110 mit dem in Figur 2 näher abgebildeten ersten Anschluss 200a des Kondensators 200 verbunden wird. Die Ladeschaltung 110 weist vorteilhaft eine nicht näher dargestellte Konstantstromquelle auf, so dass der Kondensator 200 in dem Schritt 310 mit einem konstanten Ladestrom aufgeladen wird und die zeitliche Änderung der sich an dem Kondensator 200 einstellenden Ladespannung ebenfalls konstant ist.

Die Konstantstromquelle der Ladeschaltung 110 kann beispielsweise eine Spannungsreferenz und einen Referenzwiderstand aufweisen, die den Ladestrom gewünschter Stromstärke erzeugen. Über einen Stromspiegel kann der Ladestrom in bekannter Weise an dem mit dem Kondensator 200 verbundenen Ausgang der Ladeschaltung 110 bereitgestellt werden.

Vor dem Aufladen 310 ist durch kurzzeitiges Schließen des Schalters 140 sicherzustellen, dass der Kondensator 200 völlig entladen ist, um eine nachfolgende Auswertung des Ladevorgangs nicht zu verfälschen.

Die Ladezeit wird in der Steuereinrichtung 130 bestimmt und kann beispielsweise als ganzzahliges Vielfaches einer Periodendauer des von der Taktgeberschaltung 150 bereitgestellten Taktsignals gewählt sein. Nach Ablauf der Ladezeit wird die Ladeschaltung 110 durch Öffnen des Schalters 160 von dem Kondensator 200 getrennt. In diesem Zustand liegt die Ladespannung, auf die der Kondensator 200 während der Ladezeit aufgeladen worden ist, an dem zweiten Eingang 120b der Komparatorschaltung 120 an.

Dem ersten Eingang 120a der Komparatorschaltung 120 ist ein einer Referenzspannung V_ref entsprechendes Bezugspotential zugeführt. Die Referenzspannung V_ref ist so gewählt, dass sie derjenigen Ladespannung entspricht, die ein vollständig abgeglichener Kondensator 200 nach der Ladezeit aufweist. D.h., anhand der Übereinstimmung der tatsächlichen Ladespannung des Kondensators 200 mit der Referenzspannung V_ref ist ersichtlich, dass der für den Abgleichzyklus gewählte Vorgabewert für die Kapazität des Kondensators 200 der angestrebten Sollkapazität entspricht. Die Übereinstimmung der tatsächlichen Ladespannung des Kondensators 200 mit der Referenzspannung V_ref kennzeichnet demnach den abgeglichenen Zustand.

In Schritt 320 (Figur 3a) wird nunmehr die tatsächliche Ladespannung des Kondensators 200 mit der Referenzspannung V_ref verglichen, und an dem Ausgang 120c der Komparatorschaltung 120 wird ein entsprechendes Vergleichsergebnis erhalten, das u.a. von der Steuereinrichtung 130 ausgewertet wird, um ggf. weitere Abgleichzyklen zu steuern.

Erfindungsgemäß wird der Vorgabewert für die Kapazität 200 für einen nachfolgenden Abgleichzyklus in Abhängigkeit des Vergleichsergebnisses mindestens eines vorhergehenden Abgleichzyklus gewählt. Beispielsweise wird bei der Auswertung des ersten Abgleichzyklus in dessen Schritt 320 festgestellt, dass die Ladespannung größer ist als die Referenzspannung V_ref. In diesem Fall wird darauf geschlossen, dass der für den ersten Abgleichzyklus gewählte Vorgabewert für die Kapazität des Kondensators 200 zu klein war.

Dementsprechend wird für den nachfolgenden Abgleichzyklus in dem Schritt 300 ein Vorgabewert für die Kapazität des Kondensators 200 eingestellt, der größer ist als der zuvor eingestellte Kapazitätswert, bei dem es sich wie bereits beschrieben um die minimal mögliche Kapazität des Kondensators 200 gehandelt hat. Eine entsprechende Vergrößerung der Kapazität erfolgt in dem vorliegenden Beispiel durch Hinzuschalten eines oder mehrerer der einzelnen Kondensatoren 201, .., 207 (Figur 2) zu dem fest verschalteten Kondensator 208.

Anschließend werden auch für den zweiten Abgleichzyklus die bereits beschriebenen Verfahrensschritte 310, 320 ausgeführt. Für die weiteren Abgleichzyklen kann der Vorgabewert für die Kapazität jeweils weiter erhöht werden, bis nach dem Ende eines Abgleichzyklus in dem Schritt 320 erstmals festgestellt wird, dass die Ladespannung kleiner ist als die Referenzspannung V_ref. In diesem Fall wird darauf geschlossen, dass der optimale Vorgabewert für die Kapazität des Kondensators 200 einen Wert aufweist, der zwischen dem Vorgabewert für den vorhergehenden Abgleichzyklus und dem aktuellen Abgleichzyklus liegt. Sofern die betreffende Änderung der Kapazität zwischen diesen beiden Abgleichzyklen hinreichend klein war, kann das Abgleichverfahren abgebrochen werden, weil die momentan eingestellte Kapazität des Kondensators 200 hinreichend gut mit dem Sollwert übereinstimmt.

Die Konfiguration der die einzelnen Kondensatoren 201, .., 207 verbindenden Schalter (Figur 2) wird dementsprechend beibehalten und der Kondensator 200 wird von der erfindungsgemäßen Abgleichschaltung 100 getrennt und kann anschließend beispielsweise wieder in der Filterschaltung eingesetzt werden, deren Zeitkonstante er definiert. Durch den beschriebenen erfindungsgemäßen Abgleichvorgang des Kondensators 200 stimmt diese Zeitkonstante nunmehr möglichst genau mit ihrem Sollwert überein, so dass ein ordnungsgemäßer Betrieb der Filterschaltung möglich ist.

Figur 3b gibt die Verfahrensschritte einer besonders bevorzugten Ausführungsform des erfindungsgemäßen Abgleichverfahrens an, bei der die Schrittweite, um die der Vorgabewert für die Kapazität des Kondensators 200 zwischen zwei aufeinanderfolgenden Abgleichzyklen geändert wird, in besonders zweckmäßiger Weise gewählt wird.

In Schritt 330 wird zunächst ein erster Abgleichzyklus durchgeführt, bei dem wiederum als Vorgabewert für die Kapazität des Kondensators 200 vorteilhaft der minimal mögliche Kapazitätswert eingestellt wird. Hinsichtlich der einzelnen Schritte eines Abgleichzyklus wird auf das Flussdiagramm gemäß Figur 3a verwiesen. Anschließend folgt in Schritt 340 ein weiterer Abgleichzyklus mit einem um eine vorgebbare Schrittweite geänderten, d.h. vergrößerten, Vorgabewert für die Kapazität.

Schließlich wird in Schritt 350 ermittelt, ob das Vergleichsergebnis des aktuellen Abgleichzyklus 340 identisch ist mit dem Vergleichsergebnis des vorhergehenden Abgleichzyklus 330. Ist dies der Fall, wird der nachfolgende Abgleichzyklus 360 ebenfalls mit einem Vorgabewert für die Kapazität durchgeführt, der sich um die vorgebbare Schrittweite von dem zuvor verwendeten Vorgabewert unterscheidet. D.h., für den nachfolgenden Abgleichzyklus 360 wird die Schrittweite beibehalten.

Falls das Vergleichsergebnis des aktuellen Abgleichzyklus 340 nicht identisch ist mit dem Vergleichsergebnis des vorhergehenden Abgleichzyklus 330, dann wird die Schrittweite für den nachfolgenden Abgleichzyklus 360 verringert, insbesondere halbiert, was in Schritt 355 erfolgt. D.h., falls in dem aktuellen Abgleichzyklus 340 festgestellt wird, dass die Ladespannung kleiner ist als die Referenzspannung V_ref, während die Ladespannung in dem vorhergehenden Abgleichzyklus 330 noch größer war als die Referenzspannung V_ref, wird die Schrittweite für zukünftige Abgleichzyklen 360 verringert, um eine feinere Annäherung des Vorgabewerts für die Kapazität an den Sollwert zu erreichen. Darüberhinaus wird die Änderung des Vorgabewerts um die neue Schrittweite nunmehr in der anderen Richtung als seither durchgeführt. Im vorliegenden Falle wird der Vorgabewert für den nächsten Abgleichzyklus also um die neue, halbierte Schrittweite verringert, anstelle ihn weiter zu vergrößern, usw. Hierdurch nähert sich der Vorgabewert asymptotisch an den Sollwert an.

Nach der Verringerung der Schrittweite in Schritt 355 wird in Schritt 356 noch geprüft, ob die nunmehr verringerte Schrittweite einen vorgebbaren Schwellwert unterschreitet, und das Abgleichverfahren wird gegebenenfalls abgebrochen. Beispielsweise kann der Vergleich gemäß Schritt 356 ergeben, dass die für zukünftige Abgleichzyklen 360 zu verwendende Schrittweite geringer ist als die kleinstmögliche Abstufung bei der Einstellung der Kapazität des Kondensators 200, so dass eine weitere Annäherung an den Sollwert nicht mehr möglich ist.

Sofern die beschriebene Abbruchbedingung noch nicht erreicht worden ist, wird der nachfolgende Abgleichzyklus in Schritt 360 ausgeführt, und anschließend findet wiederum der Vergleich gemäß Schritt 350 statt, usw.

Neben dem Abbruchkriterium der minimal zu verwendenden Schrittweite kann auch eine maximale Anzahl von durchzuführenden Abgleichzyklen festgelegt sein, wodurch insbesondere bei Messfehlern oder z.B. aufgrund von Fertigungsfehlem sehr stark von dem Sollwert abweichenden tatsächlichen Kapazitätswerten sichergestellt ist, dass die Durchführung des Abgleichverfahrens eine vorgebbare maximale Dauer nicht überschreitet.

Ferner kann einer weiteren vorteilhaften Ausführungsform des erfindungsgemäßen Verfahrens zufolge festgelegt sein, dass zunächst zwei Abgleichzyklen durchgeführt werden, wobei für den ersten Abgleichzyklus z.B. die kleinstmögliche Kapazität des Kondensators 200 eingestellt wird, und wobei für den zweiten Abgleichzyklus z.B. die größtmögliche Kapazität des Kondensators 200 eingestellt wird. Sofern beide Abgleichzyklen dasselbe Vergleichsergebnis liefern, kann davon ausgegangen werden, dass der gesamte Wertebereich der einstellbaren Kapazität nicht den angestrebten Sollwert enthält. Auf diese Weise kann sehr schnell ermittelt werden, dass ein Abgleich durch entsprechendes Einstellen der Kapazität des Kondensators 200 nicht möglich ist. In solchen Fällen ist allenfalls durch eine Variation der Ladezeit und die damit einhergehende "Erweiterung" des Wertebereichs des Kondensators 200 ggf. zumindest die tatsächliche Kapazität des Kondensators 200 feststellbar.

Das erfindungsgemäße Verfahren ist besonders vorteilhaft, weil es im Gegensatz zu herkömmlichen Abgleichverfahren keine aufwendige und ungenaue Messung von Pulsdauern eines Referenzsignals erfordert sondern nur einen verhältnismäßig einfachen Spannungsvergleich mittels der Komparatorschaltung 120. Im günstigsten Fall sind lediglich zwei Abgleichschritte erforderlich; dies ist der Fall, wenn die Schrittweite für die jeweiligen Vorgabewerte für die Kapazität hinreichend klein gewählt ist und bereits das Vergleichsergebnis des zweiten Abgleichzyklus von demjenigen des ersten Abgleichzyklus abweicht.

Üblicherweise sind mehr als zwei Abgleichzyklen durchzuführen, wobei die genaue Anzahl von der gewünschten Präzision abhängt. Da die Ladezeit bei der vorstehend beschriebenen bevorzugten Ausführungsform i.d.R. stets konstant bleibt, ist die maximale Dauer des gesamten Abgleichvorgangs abschätzbar als ganzzahliges Vielfaches der Dauer eines Abgleichzyklus multipliziert mit der Anzahl der maximal zu testenden verschiedenen Vorgabewerte für die Kapazität des Kondensators 200.

Obwohl die vorstehend beschriebenen Verfahrensvarianten als Ausgangswert für die Kapazität jeweils den minimal möglichen Kapazitätswert des Kondensators 200 verwendet haben, ist es auch denkbar, von dem maximal möglichen Kapazitätswert des Kondensators 200 auszugehen oder z.B. von einem Kapazitätswert, der etwa in der Mitte des möglichen Wertebereichs liegt.

Anstelle einer variablen Schrittweite für die Veränderung der Vorgabewerte für die Kapazität zwischen aufeinanderfolgenden Abgleichzyklen kann auch eine konstante Schrittweite gewählt werden. In diesem Fall ist die erzielbare Präzision jedoch direkt durch die konstante Schrittweite begrenzt.

Es ist darüber hinaus auch denkbar, zwei oder mehr Abgleichdurchläufe vorzunehmen, bei denen jeweils konstante Schrittweiten verwendet werden. Beispielsweise kann in einem ersten Abgleichdurchlauf eine verhältnismäßig große Schrittweite verwendet werden, um mit wenigen Abgleichzyklen eine grobe Näherung für den optimalen Vorgabewert für die Kapazität zu erhalten. In einem zweiten Abgleichdurchlauf kann das in dem ersten Abgleichdurchlauf bestimmte Intervall von Kapazitätswerten schließlich durch mehrere Abgleichzyklen mit verhältnismäßig kleiner aber konstanter Schrittweite weiter untersucht werden.

Ferner ist es bei einer weiteren Ausführungsform des erfindungsgemäßen Verfahrens vorgesehen, dass die Schrittweite in Abhängigkeit der Anzahl bereits durchgeführter Vergleichszyklen bzw. Abgleichzyklen gewählt wird.

Bei einer weiteren ganz besonders vorteilhaften Ausführungsform des erfindungsgemäßen Verfahrens ist vorgesehen, dass alternativ oder ergänzend zu dem Vorgabewert für die Kapazität die Ladezeit für einen nachfolgenden Abgleichzyklus in Abhängigkeit des Vergleichsergebnisses mindestens eines vorhergehenden Abgleichzyklus gewählt wird.

Diese Erfindungsvariante ermöglicht insbesondere bei einem Aufladen des Kondensators 200 mittels eines konstanten Stroms eine einfache Erweiterung des zur Verfügung stehenden Messbereichs. Beispielsweise kann eine Halbierung des bei dem Kondensator 200 eingestellten Kapazitätswerts dadurch simuliert werden, dass die Ladezeit gegenüber ihrem Nominalwert verdoppelt wird, usw. Obwohl in diesem Fall u.U. kein tatsächlicher Abgleich des Kondensators 200 in der Form möglich ist, dass entsprechende einzelne Kondensatoren 201, .., 207 hinzugeschaltet werden und damit der Sollwert für die Kapazität eingestellt wird, weil der erweiterte untersuchte Wertebereich durch die Variation der Ladezeit und nicht durch das tatsächliche Einstellen eines Vorgabewerts für die Kapazität erfolgt, kann jedenfalls die tatsächliche Kapazität des Kondensators 200 in dem durch die Variation der Ladezeit erweiterten Wertebereich für die Kapazität ermittelt werden und ggf. einer den Kondensator 200 verwendenden Filterschaltung (nicht gezeigt) als Kalibrierdaten zur Verfügung gestellt werden.

Durch das erfindungsgemäße Abgleichverfahren ist die Verwendung einer verhältnismäßig einfachen Abgleichschaltung 100 möglich, und es kann insbesondere auf die aus dem Stand der Technik bekannte Messung der Pulsdauer eines Referenzsignals verzichtet werden. Darüberhinaus benötigt die erfindungsgemäße Schaltung 100 weitaus weniger Chipfläche, als herkömmliche Abgleichschaltungen, bei denen die Kapazität des kapazitiven Elements gezielt vergrößert wird, um die dadurch definierte Zeitkonstante und damit die zu messende Pulsdauer zu vergrößern, so dass ein zur Messung der Pulsdauer verwendetes hochfrequentes Taktsignal nur noch eine entsprechend der Vergrößerung der Zeitkonstante verringerte Taktfrequenz aufweisen muss, um dieselbe Genauigkeit zu liefern. Im Gegensatz zu den herkömmlichen Abgleichschaltungen und -verfahren wird die Präzision des erfindungsgemäßen Verfahrens durch die Abstufung der Kapazitätswerte des Kondensators 200 bestimmt, so dass nicht notwendig besonders große Kapazitätswerte vorzusehen sind sondern vielmehr eine kleinere Abstufung der einstellbaren Kapazitätswerte. Insgesamt kann der Bedarf an Chipfläche bei gleichbleibender Genauigkeit durch die Erfindung um etwa 75% reduziert werden.

Die erfindungsgemäße Schaltung 100 ist aufgrund ihres geringen Bedarfs an Chipfläche besonders gut integrierbar, und die einzelnen Kondensatoren des kapazitiven Elements 200 können beispielsweise als MIM (metal insulator metal)-Kondensatoren ausgebildet sein.

Bei einer weiteren sehr vorteilhaften Ausführungsform der vorliegenden Erfindung ist vorgesehen, dass anstelle der Änderung des Vorgabewerts für die Kapazität des Kondensators 200, vgl. Figur 1, eine Änderung des Vorgabewerts für den Widerstand eines nicht abgebildeten resistiven Elements vorgenommen wird, das mit dem kapazitiven Element 200 zusammen das abzugleichende RC-Glied bildet. Das erfindungsgemäße Verfahren ist analog anwendbar, und ein entsprechend abstimmbares resistives Element kann beispielsweise als konfigurierbare Widerstandsmatrix mit einer Mehrzahl einzelner Ohmwiderstände ausgebildet sein, die analog zu den in Figur 2 abgebildeten einzelnen Kondensatoren miteinander verschaltbar sind, um jeweils einen unterschiedlichen Ersatzwiderstand zu realisieren. Das resistive Element kann in diesem Fall beispielsweise so in die Ladeschaltung 110 integriert bzw. in diese integrierbar ausgelegt sein, dass es durch seinen Widerstand direkt den Ladestrom zum Aufladen des Kondensators 200 bestimmt, so dass sein Widerstandswert die erfindungsgemäß untersuchte Ladezeit mitbestimmt. Generell kann alternativ oder ergänzend zur Verwendung von schaltbaren Ohmwiderständen auch jede andere Art vorzugsweise integrierbarer steuerbarer Widerstände verwendet werden.

Alternativ zu der vorstehend beschriebenen Integration des resistiven Elements in der Ladeschaltung 110 kann das resistive Element auch anstelle der in Figur 1 abgebildeten Ladeschaltung 110 vorgesehen sein bzw. selbst die Ladeschaltung 110 bilden. In diesem Fall ist das resistive Element über den Schalter 160 mit dem Kondensator 200 verbindbar, mit dem es das abzugleichende RC-Glied bildet. An dem nicht mit dem Schalter 160 verbundenen Anschluss des resistiven Elements kann vorteilhaft eine Referenzspannungsquelle angeschlossen werden, um einen RC-Aufladevorgang des RC-Gliedes zu ermöglichen. Wie bereits beschrieben ist bei einer derartigen Aufladung des Kondensators 200 die Ladezeit vorteilhaft so zu wählen, dass sie kleiner ist als die durch das RC-Glied definierte Zeitkonstante, um einen vorwiegend linearen Bereich des Zeitverlaufs des Ladestroms bzw. der Ladespannung für den erfindungsgemäßen Abgleich zu nutzen und nicht den asymptotischen Bereich bei Ladezeiten, die einem Vielfachen der Zeitkonstante entsprechen.

Auch bei der Veränderung des Vorgabewerts für den Widerstand sowie bei einer Veränderung der Vorgabewerte für Kapazität und Widerstand kann bei Bedarf zusätzlich die Ladezeit verändert werden, um die Wertebereiche der beteiligten Bauelemente in der bereits beschriebenen Weise zu vergrößern.

## Patentansprüche

1. Verfahren zum Abgleichen eines RC-Gliedes mit einem kapazitiven Element (200) mit einstellbarer Kapazität, insbesondere einem Kondensator, und/oder einem resistiven Element mit einstellbarem Widerstand, insbesondere einem Ohmwiderstand, **dadurch gekennzeichnet, dass** mehrere Abgleichzyklen durchgeführt werden, wobei jeder Abgleichzyklus die folgenden Schritte aufweist:
a) Einstellen (300) eines Vorgabewerts für die Kapazität des kapazitiven Elements (200) und/oder für den Widerstand des resistiven Elements,
b) Aufladen (310) des kapazitiven Elements (200) für eine vorgebbare Ladezeit,
c) Vergleichen (320) einer Ladespannung, auf die das kapazitive Element (200) während der Ladezeit aufgeladen worden ist, mit einer Referenzspannung (V_ref), wobei ein Vergleichsergebnis erhalten wird, das angibt, ob die Ladespannung größer ist als die Referenzspannung (V_ref) oder umgekehrt,
und dass der Vorgabewert für die Kapazität und/oder den Widerstand und/oder die Ladezeit für einen nachfolgenden Abgleichzyklus in Abhängigkeit des Vergleichsergebnisses mindestens eines vorhergehenden Abgleichzyklus gewählt wird.

2. Verfahren nach Anspruch 1, **dadurch gekennzeichnet, dass** der Vorgabewert für die Kapazität für den nächsten Abgleichzyklus erhöht/verringert wird und/oder dass der Vorgabewert für den Widerstand für den nächsten Abgleichzyklus erhöht/verringert wird, wenn die Ladespannung bei dem vorhergehenden Abgleichzyklus größer/kleiner war als die Referenzspannung (V_ref).

3. Verfahren nach Anspruch 1 oder 2, **dadurch gekennzeichnet, dass** die Ladezeit für den nächsten Abgleichzyklus erhöht/verringert wird, wenn die Ladespannung bei dem vorhergehenden Abgleichzyklus kleiner/größer war als die Referenzspannung (V_ref).

4. Verfahren nach einem der vorstehenden Ansprüche, **dadurch gekennzeichnet, dass** das kapazitive Element (200) durch eine Ladeschaltung (110) mit einem konstanten Strom aufgeladen wird.

5. Verfahren nach einem der Ansprüche 1 bis 3, **dadurch gekennzeichnet, dass** das kapazitive Element (200) mittels einer Ladeschaltung (110) über einen Vorwiderstand und eine Referenzspannungsquelle aufgeladen wird, wobei der Vorwiderstand vorzugsweise zumindest teilweise durch das resistive Element gebildet ist.

6. Verfahren nach einem der vorstehenden Ansprüche, **dadurch gekennzeichnet, dass** als Vorgabewert für einen ersten Abgleichzyklus eine maximal bzw. minimal einstellbare Kapazität des kapazitiven Elements (200) und/oder ein maximal bzw. minimal einstellbarer Widerstand des resistiven Elements gewählt wird.

7. Verfahren nach einem der vorstehenden Ansprüche, **dadurch gekennzeichnet, dass** der Vorgabewert zwischen aufeinanderfolgenden Abgleichzyklen jeweils um eine vorgebbare Schrittweite geändert wird.

8. Verfahren nach Anspruch 7, **dadurch gekennzeichnet, dass** die Schrittweite konstant ist.

9. Verfahren nach Anspruch 7, **dadurch gekennzeichnet, dass** die Schrittweite variabel ist.

10. Verfahren nach Anspruch 9, **dadurch gekennzeichnet, dass** die Schrittweite in Abhängigkeit der Anzahl bereits durchgeführter Abgleichzyklen gewählt wird.

11. Verfahren nach Anspruch 9, **gekennzeichnet durch** die folgenden Schritte:
- Beibehalten der momentanen Schrittweite für den nächsten Abgleichzyklus, falls das Vergleichsergebnis des aktuellen Abgleichzyklus identisch ist mit dem Vergleichsergebnis des vorhergehenden Abgleichzyklus,
- Verringern, insbesondere Halbieren, der momentanen Schrittweite für den nächsten Abgleichzyklus, falls das Vergleichsergebnis des aktuellen Abgleichzyklus nicht identisch ist mit dem Vergleichsergebnis des vorhergehenden Abgleichzyklus,
- Beenden des Abgleichs, sobald die für den nächsten Abgleichzyklus gewählte Schrittweite einen vorgebbaren Schwellwert unterschreitet.

12. Verfahren nach einem der vorstehenden Ansprüche, **dadurch gekennzeichnet, dass** das kapazitive Element (200) nach dem Schritt des Vergleichens entladen wird.

13. Verfahren nach einem der vorstehenden Ansprüche, **dadurch gekennzeichnet, dass** eine zum Aufladen des kapazitiven Elements (200) verwendete Ladeschaltung (110) vor dem Schritt des Vergleichens von dem kapazitiven Element (200) getrennt wird.

14. Schaltung (100) zum Abgleichen eines RC-Gliedes mit einem kapazitiven Element (200) mit einstellbarer Kapazität, insbesondere einem Kondensator, und/oder einem resistiven Element mit einstellbarem Widerstand, insbesondere einem Ohmwiderstand, wobei die Schaltung (100) aufweist: eine mindestens mit einem ersten Anschluss des kapazitiven Elements (200) verbindbare Ladeschaltung (110) zum Aufladen des kapazitiven Elements (200), eine Komparatorschaltung (120) mit einem ersten Eingang (120a), einem zweiten Eingang (120b) und mit einem Ausgang (120c), wobei dem ersten Eingang (120a) ein einer Referenzspannung (V_ref) entsprechendes Bezugspotential zugeführt ist, und wobei der zweite Eingang (120b) mit dem ersten Anschluss des kapazitiven Elements (200) verbindbar ist, und eine Steuereinrichtung (130), die zur Steuerung der Schaltung (100) gemäß dem Abgleichverfahren nach einem der vorstehenden Ansprüche konfiguriert ist.

15. Schaltung (100) nach Anspruch 14, **dadurch gekennzeichnet, dass** die Steuereinrichtung (130) einen Zustandsautomaten (135) aufweist und/oder als Zustandsautomat ausgebildet ist.

16. Schaltung (100) nach einem der Ansprüche 14 bis 15, **gekennzeichnet durch** eine mit mindestens einem Anschluss des kapazitiven Elements (200) verbindbare Entladeschaltung (140) zum Entladen des kapazitiven Elements (200).

17. Schaltung (100) nach einem der Ansprüche 14 bis 16, **gekennzeichnet durch** eine Taktgeberschaltung (150) zur Erzeugung eines Taktsignals.

18. Schaltung (100) nach einem der Ansprüche 14 bis 17, **gekennzeichnet durch** Schaltermittel (160) zum Verbinden der Ladeschaltung (110) mit dem kapazitiven Element (200).
